# EUROPÄISCHE PATENTSCHRIFT

(11) **EP 0 843 178 B1**
(45) Veröffentlichungstag und Bekanntmachung des Hinweises auf die Patenterteilung: **09.02.2005**
(21) Anmeldenummer: 97203475.5
(22) Anmeldetag: 10.11.1997
(51) Int. Cl.: G01R 33/567

(54) **MR-Verfahren zur Reduzierung von Bewegungsartefakten und Anordnung zur Durchführung des Verfahrens**
MR method for the reduction of motion artifacts and apparatus for carrying out the method
Procédé RM de réduction d'artefacts de bouge et appareil pour exécuter la méthode

(30) Priorität: 16.11.1996 DE 19647537
(43) Veröffentlichungstag der Anmeldung: 20.05.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Rasche, Volker, Dr., Röntgenstrasse 24, 22335 Hamburg (DE); Proska, Roland, Röntgenstrasse 24, 22335 Hamburg (DE)
(74) Vertreter: Volmer, Georg, Dipl.-Ing.

(56) Entgegenhaltungen:
- WO-A-90/05920
- DE-A- 4 319 539
- US-A- 5 377 680
- US-A- 5 382 902
- PATENT ABSTRACTS OF JAPAN vol. 17, no. 708 (C-1147), 24.Dezember 1993 & JP 05 245128 A (HITACHI LTD), 24.September 1993,

## Beschreibung

Die Erfindung betrifft ein Magnetresonanz-Verfahren (im folgenden MR-Verfahren) zur Reduzierung von Bewegungsartefakten, bei dem zeitlich nacheinander mehrere MR-Datensätze eines Untersuchungsobjektes erfaßt werden.

Die Erfindung betrifft weiterhin eine MR-Anordnung zur Durchführung des Verfahrens mit Mitteln zum Erzeugen von MR-Bildern aus MR-Signalen, einer programmierbaren Steuereinheit zum Steuern der vorgenannten Mittel und einer Rekonstruktionseinheit zum Rekonstruieren von MR-Bildern nach der Projektions-Rekonstruktions-Methode.

Ein derartiges MR-Verfahren und eine derartige MR-Anordnung sind aus der US-PS 5,502,385 bekannt. Gemäß dem darin beschriebenen Verfahren wirken MR-Sequenzen mit fortlaufend veränderten magnetischen Gradientenfeldern auf das Untersuchungsobjekt ein. Aus den dabei erzeugten MR-Signalen werden MR-Bilder rekonstruiert, wobei die ältesten zur Rekonstruktion eines MR-Bildes herangezogenen MR-Signale bei der Rekonstruktion des nachfolgenden MR-Bildes durch die jeweils neu erzeugten MR-Signale ersetzt werden. Dabei läßt sich eine artefaktarme Darstellung von dynamischen Vorgängen im Untersuchungsbereich dadurch erreichen, daß die Richtung des während der Erzeugung eines MR-Signales wirksamen magnetischen Gradientenfeldes von Sequenz zu Sequenz so geändert wird, daß der Bereich der für die Rekonstruktion erforderlichen Richtungen des magnetischen Gradientenfeldes gleichmäßig auf die jeweils neu erzeugten MR-Signale verteilt ist.

Die Erfassung eines MR-Datensatzes eines bewegten Objektes zur Darstellung eines hochaufgelösten MR-Bildes benötigt im allgemeinen einen im Vergleich zur Bewegung des Objektes nicht vernachlässigbaren Zeitraum. Aufgrund der Bewegung des Untersuchungsobjektes im Verlauf der Datenakquisition können deshalb im rekonstruierten hochaufgelösten MR-Bild beim bekannten Verfahren Artefakte auftreten. Bei Vorgabe einer bestimmten Auflösung im MR-Bild ist eine Reduzierung der Meßzeit jedoch im allgemeinen nur sehr beschränkt realisierbar.

Weiterhin ist aus der US PS 5,382,902 ein MR-Verfahren bekannt, bei dem eine Sequenz mit einer bei jeder Wiederholung variierten Phasenkodierung auf einen Untersuchungsbereich einwirkt. Die MR-Signale werden einer ersten Fourier-Transformation unterzogen, sodaß sich phasenkodierte Projektionen ("projection views") ergeben. Von solchen Projektionen mit verschiedener Phasenkodierung werden die Kanten bzw. die Ränder des Objektes detektiert. Aus der Verschiebung dieser Ränder in verschiedenen Projektionen infolge einer Bewegung des Objektes werden Informationen über diese Bewegung abgeleitet, mit denen die Projektionen korrigiert werden, bevor daraus durch eine zweite Fourier-Transformation (in Phasenkodierrichtung) ein Bild rekonstruiert wird.

Die Korrektur der Bewegungsartefakte gelingt mit diesem Verfahren allerdings nur in einem begrenzten Maße. Voraussetzung für seine Anwendbarkeit ist zunächst, daß das sog "field of view" so groß gewählt ist, daß die Ränder des Objektes von den Projektionen erfaßt werden; andernfalls kann aus den Projektionen keine Informationen über die Bewegung abgeleitet werden. Weiterhin ist damit allenfalls eine Korrektur von Bewegungen in Leserichtung möglich; eine Korrektur von Bewegungen in Phasenkodierrichtung gelingt nur durch die Akquisition von zusätzlichen Navigator Echos, wodurch sich die Zeit für die Akquisition der für ein Bild benötigten MR-Signale - und damit auch die Wahrscheinlichkeit von Bewegungsartefakten in dem Bild - vergrößert. Außerdem kann man nur eine Bewegung der Ränder detektieren; eine Detektion einer davon abweichenden Bewegungskomponente in dem Bereich zwischen den Rändern ist nicht möglich. Schließlich ist es überhaupt problematisch, aus einem Vergleich zweier Projektionen mit unterschiedlicher Phasenkodierung Informationen über die Bewegung des Objektes abzuleiten, weil diese Projektionen sich auch bei einem unbewegten Objekt voneinander unterscheiden. Um dieses Problem zu vermeiden, soll die Sequenz mit derselben niedrigen (vorzugsweise fehlenden) Phasenkodierung wiederholt werden, - wodurch sich ebenfalls die Zeit für die Akquisition der für ein Bild benötigten MR-Signale, und damit auch die Wahrscheinlichkeit von Bewegungsartefakten in dem Bild, vergrößert.

Der Erfindung liegt die Aufgabe zugrunde, ein MR-Verfahren und eine MR-Anordnung der eingangs genannten Art derart auszugestalten, daß bei dynamischen Vorgängen im Untersuchungsbereich in hochaufgelösten MR-Bildern weniger Artefakte auftreten.

Diese Aufgabe betreffend das MR-Verfahren wird erfindungsgemäß durch die im Anspruch 1 angegebenen Maßnahmen gelöst. Gemäß der Erfindung wird der Zeitraum, der erforderlich ist zur Erfassung eines einzigen MR-Datensatzes, aus dem ein hochaufgelöstes MR-Bild rekonstruiert werden kann, aufgeteilt in mehrere (kürzere) Zeiträume, in denen jeweils ein MR-Datensatz erfaßt wird. Aus jedem MR-Datensatz kann ein niedrigaufgelöstes MR-Bild rekonstruiert werden. Niedrigaufgelöst bedeutet in diesem Zusammenhang, daß der für die Rekonstruktion benötigte MR-Datensatz mittels einer geringeren Anzahl von MR-Sequenzen erfaßt wird als ein MR-Datensatz zur Rekonstruktion eines hochaufgelösten MR-Bildes. Im sogenannten k-Raum (Ortsfrequenzraum) bedeutet dies, daß der k-Raum auf weniger Pfaden abgetastet wird als zur Rekonstruktion eines hochaufgelösten MR-Bildes und daß deshalb die Dichte der Abtastpunkte in angularer Richtung im k-Raum geringer ist.

Die Bild-Transformationsparameter beschreiben, wie sich die Lage einzelner Bildpunkte, Bildsegmente oder ganzer Bildobjekte (z.B. Knochen) in den aufeinanderfolgenden niedrigaufgelösten MR-Bildern verändert hat. Jedem Bildpunkt, Bildsegment bzw. Bildobjekt wird dabei ein aus dem Vergleich zweier bevorzugt zeitlich aufeinanderfolgender niedrigaufgelöster MR-Bilder ein Bild-Transformationsparameter zugewiesen, der die Veränderung der Lage des Bildpunktes, Bildsegmentes bzw. Bildobjektes vom ersten zum zweiten der miteinander verglichenen MR-Bilder quasi als Bewegungsvektor beschreibt. Die aus dem Vergleich zweier niederaufgelöster MR-Bilder gewonnenen Bild-Transformationsparameter könnten beispielsweise in Form einer Bild-Transformationsmatrix (ein sog. Bewegungsvektorfeld) zusammengefaßt werden.

Aus diesen Bild-Transformationsparamentern und den MR-Datensätzen, aus denen die niedrigaufgelösten MR-Bilder rekonstruiert sind, kann dann ein hochaufgelöstes MR-Bild rekonstruiert werden, welches keine oder nur geringe Bewegungsartefakte aufweist unter der Voraussetzung, daß während der Erfassung der MR-Datensätze die Objekte im Untersuchungsbereich lediglich verschoben, gedreht oder verzerrt wurden, aber keine neuen Objekte in den Untersuchungsbereich gekommen sind.

Es ist erfindungsgemäß vorgesehen, daß die Lage von Bildpunkten in einem als Referenzbild dienenden niedrigaufgelösten MR-Bild bestimmt wird, daß die Lage der Bildpunkte in den übrigen niedrigaufgelösten MR-Bildern bestimmt wird und daß aus dem Vergleich der Lage der Bildpunkte im Referenzbild mit der Lage der Bildpunkte in den übrigen niedrigaufgelösten MR-Bildern die Bild-Transformationsparameter ermittelt werden. Als Referenzbild dient vorteilhafterweise das aus dem zeitlich zuerst erfaßten MR-Datensatz rekonstruierte niedrigaufgelöste MR-Bild, wobei die Bild-Transformationsparameter dann die Verschiebung der Bildpunkte in den nachfolgenden MR-Bildern beschreiben. Es kann jedoch auch ein anderes MR-Bild als Referenzbild ausgewählt werden.

Ausgehend davon ist in einer weiteren Ausgestaltung der Erfindung vorgesehen, daß im Referenzbild die Lage von Bildpunkten an Stellen bestimmt wird, die Rasterpunkten eines Rasters entsprechen, auf dem das hochaufgelöste MR-Bild rekonstruiert wird. Da bei der Rekonstruktion des hochaufgelösten MR-Bildes die Bild-Transformationsparameter berücksichtigt werden, ist es vorteilhaft, wenn bei der Bestimmung der Bild-Transformationsparameter dasselbe Raster zugrunde gelegt wird, das auch bei der Rekonstruktion des hochaufgelösten MR-Bildes verwendet wird. Dazu wird das (niedrigaufgelöste) Referenzbild entsprechend diesem Raster unterteilt - vorteilhafterweise werden sowohl das Referenzbild als auch die übrigen niedrigaufgelösten MR-Bilder auf diesem Raster rekonstruiert - und die Lage von Bildpunkten an den Rasterpunkten dieses Rasters im Referenzbild bestimmt und in den übrigen niedrigaufgelösten MR-Bildern verfolgt werden. Andernfalls würde der Rechenaufwand bei der Rekonstruktion des hochaufgelösten MR-Bildes zusätzlich erhöht werden, da zunächst die Bild-Transformationsparameter an das Raster zur Rekonstruktion des hochaufgelösten Bildes angepaßt werden müßten, bevor das hochaufgelöste Bild rekonstruiert werden könnte.

Eine besonders vorteilhafte Weiterbildung der Erfindung sieht vor, daß die Bildwerte des hochaufgelösten MR-Bildes jeweils durch eine Addition von Teil-Bildwerten ermittelt werden, von denen ein erster Teil-Bildwert aus einem ersten MR-Datensatz durch Rekonstruktion auf einem Rasterpunkt eines Grundrasters ermittelt wird und die weiteren Teil-Bildwerte jeweils aus einem der übrigen MR-Datensätze durch Rekonstruktion auf einem Rasterpunkt eines Rasters ermittelt werden, welches aus dem Grundraster mittels der zugehörigen Bild-Transformationsparameter ermittelt wird. Ein Bildwert des hochaufgelösten MR-Bildes setzt sich aus mehreren Teil-Bildwerten zusammen, wobei die Anzahl der Teil-Bildwerte der Anzahl der MR-Datensätze entspricht. Aus jedem MR-Datensatz wird dabei ein Teil-Bildwert ermittelt. Zunächst wird der erste Teil-Bildwert auf einem Rasterpunkt des Grundrasters rekonstruiert. Danach wird dieser Rasterpunkt mittels des zugehörigen Bild-Transformationsparameters verschoben und die neue Lage des Rasterpunktes bestimmt. An dieser Stelle erfolgt dann die Rekonstruktion des nächsten Teil-Bildwertes aus dem zugehörigen nächsten MR-Datensatz. Dieses Vorgehen wird für alle MR-Datensätze wiederholt. Anschließend werden alle ermittelten Teil-Bildwerte addiert, woraus sich der Bildwert des hochaufgelösten MR-Bildes ergibt. Die Position dieses Bildwertes im hochaufgelösten MR-Bild entspricht der Position des Rasterpunktes des Grundrasters, auf dem der erste Teil-Bildwert rekonstruiert wurde. Dadurch werden Bewegungen, die während der Erfassung der MR-Datensätze im Untersuchungsbereich erfolgt sind, berücksichtigt und bei der Rekonstruktion des hochaufgelösten Bildes quasi rückwirkend aus den MR-Datensätzen herausgerechnet.

Eine weitere Ausgestaltung sieht erfindungsgemäß vor, daß zur Rekonstruktion des hochaufgelösten MR-Bildes aus einem MR-Datensatz ein MR-Grundbild auf einem Grundraster erstellt wird, daß aus den übrigen MR-Datensätzen jeweils ein MR-Bild auf einem weiteren Raster erstellt wird, welches aus dem Grundraster mittels der zugehörigen Bild-Transformationsparameter ermittelt wird, und daß das MR-Grundbild und die MR-Bilder zu einem hochaufgelösten MR-Bild überlagert werden. Hierbei wird eine während der Erfassung der MR-Datensätze erfolgte Bewegung dadurch berücksichtigt, daß das Grundraster mittels der Bild-Transformationsparameter in weitere Raster transformiert wird, auf denen dann die MR-Bilder aus den zu den transformierten Rastern gehörigen MR-Datensätzen rekonstruiert werden. Diese MR-Bilder sind im allgemeinen nicht darstellbar, da die transformierten Raster im allgemeinen keine Regelmäßigkeit wie beispielsweise ein kartesisches Raster aufweisen. Wegen der Linearität der Rekonstruktion ergibt sich das hochaufgelöste MR-Bild durch Überlagerung (Summation) des MR-Grundbildes und der MR-Bilder.

Bevorzugt ist in einer Ausgestaltung der Erfindung vorgesehen, daß zur Erfassung eines MR-Datensatzes der k-Raum auf in radialer Richtung durch den Null-Punkt des k-Raumes verlaufenden Pfaden abgetastet wird. Dazu weisen die MR-Sequenzen unterschiedliche Phasenkodierungsgradienten auf. Diese radiale Abtastung des k-Raumes hat den Vorteil, daß auf einfache Weise mittels der Projektions-Rekonstruktions-Methode MR-Bilder erstellt werden können.

Davon ausgehend ist weiter in einer Ausgestaltung vorgesehen, daß die zur Erfassung eines MR-Datensatzes durchlaufenen Pfade sich unter einem Winkel mit den zur Erfassung der weiteren MR-Datensätze durchlaufenen Pfaden schneiden. Bevorzugt wird dabei der k-Raum bei der Erfassung der MR-Datensätze, die zur Rekonstruktion eines hochaufgelösten MR-Bildes erforderlich sind, gleichmäßig abgetastet, wozu alle Winkel zwischen zwei benachbarten Pfaden gleich groß sind.

Die Aufgabe bezüglich des Verfahrens wird auch gelöst durch ein eingangs genanntes MR-Verfahren, daß dadurch gekennzeichnet ist, daß parallel zur Erfassung der MR-Datensätze die Lage von an vorbestimmten Positionen des Untersuchungsobjektes angeordneten Mikrospulen erfaßt wird, daß aus dem Vergleich zeitlich aufeinanderfolgender Lagedaten der Mikrospulen Bild-Transformationsparameter ermittelt werden und daß aus den MR-Datensätzen in Abhängigkeit der Bild-Transformationsparameter ein hochaufgelöstes MR-Bild rekonstruiert wird. Bei diesem Verfahren wird also nicht die Lage von Bildpunkten oder Bildobjekten in den niedrigaufgelösten MR-Bildern bestimmt und verfolgt, sondern die Lage von vorab am oder im Untersuchungsobjekt angeordneten Mikrospulen, von denen beim Erfassen der MR-Datensätze jeweils ebenfalls ein MR-Signal erfaßt wird. Daraus werden dann die Bild-Transformationsparameter ermittelt. Die Rekonstruktion des hochaufgelösten MR-Bildes erfolgt anschließend auf die bereits beschriebene Weise.

Weiterhin sieht eine Ausgestaltung der Erfindung vor, daß ein oder mehrere niedrigaufgelöste MR-Bilder und/oder das hochaufgelöste MR-Bild dargestellt werden. Dadurch ist es möglich, dem Betrachter MR-Bilder mit unterschiedlicher zeitlicher und räumlicher Auflösung angeboten. Während die niedrigaufgelösten MR-Bilder eine hohe zeitliche Auflösung auf Kosten einer niedrigen räumlichen Auflösung aufweisen, was beispielsweise für fluoroskopische Anwendungen (z.B. bei interventionellen Anwendungen) wünschenswert ist, weist das hochaufgelöste MR-Bild dagegen eine hohe räumliche Auflösung auf Kosten der zeitlichen Auflösung auf. Es kann dabei auch vorgesehen sein, dem Betrachter die Auswahl der räumlichen und/oder zeitlichen Auflösung und die Anzahl der dargestellten MR-Bilder zu ermöglichen.

Eine davon ausgehende Weiterbildung sieht vor, daß das hochaufgelöste MR-Bild ohne Berücksichtigung der Bild-Transformationsparameter aus den MR-Datensätzen rekonstruiert wird. Dem Betrachter kann also statt des in Abhängigkeit der Bild-Transformationsparameter rekonstruierten, hochaufgelösten MR-Bildes ein nach herkömmlichen Verfahren aus den MR-Datensätzen rekonstruiertes MR-Bild angeboten werden. Dieses kann zwar Bewegungsartefakte aufweisen, die Berechnung der Bild-Transformationsparameter entfällt dafür und die Rekonstruktion des hochaufgelösten MR-Bildes ist weniger rechenaufwendig. Die niedrigaufgelösten MR-Bilder können auch auf dem Raster des hochaufgelösten MR-Bildes dargestellt werden, wozu die niedrigaufgelösten MR-Bilder beispielsweise mit mathematischen Methoden geeignet gezoomt werden müssen. Die MR-Datensätze müssen bei dieser Weiterbildung nicht durch radiale Abtastung des k-Raumes gewonnen werden, die Abtastung kann auch anders erfolgen.

Die Aufgabe betreffend die MR-Anordnung wird erfindungsgemäß dadurch gelöst, daß die Steuereinheit derart programmiert ist, daß zeitlich nacheinander mehrere MR-Datensätze eines Untersuchungsobjektes erfaßt werden, daß die Rekonstruktionseinheit aus jeweils einem MR-Datensatz ein niedrigaufgelöstes MR-Bild rekonstruiert, aus dem Vergleich der niedrigaufgelösten MR-Bilder Bild-Transformationsparameter ermittelt und aus den MR-Datensätzen in Abhängigkeit der Bild-Transformationsparameter ein hochaufgelöstes MR-Bild rekonstruiert.

Die Erfindung wird nachfolgend anhand der Zeichnungen näher erläutert. Es zeigen:
- Fig. 1: ein Blockschaltbild einer MR-Anordnung, mit der die Erfindung ausführbar ist,
- Fig. 2: ein Ablaufschema zur Verdeutlichung des erfindungsgemäßen Verfahrens,
- Fig. 3: die Abtastung des k-Raumes gemäß der Erfindung,
- Fig. 4: die zeitliche Abfolge der Abtastungen gemäß Fig. 3,
- Fig. 5: mehrere aufeinander folgende niedrigaufgelöste MR-Bilder,
- Fig. 6: eine Skizze zur Veranschaulichung der Rekonstruktion des hochaufgelösten MR-Bildes gemäß der Erfindung und
- Fig. 7: zur Rekonstruktion benutzte Raster.

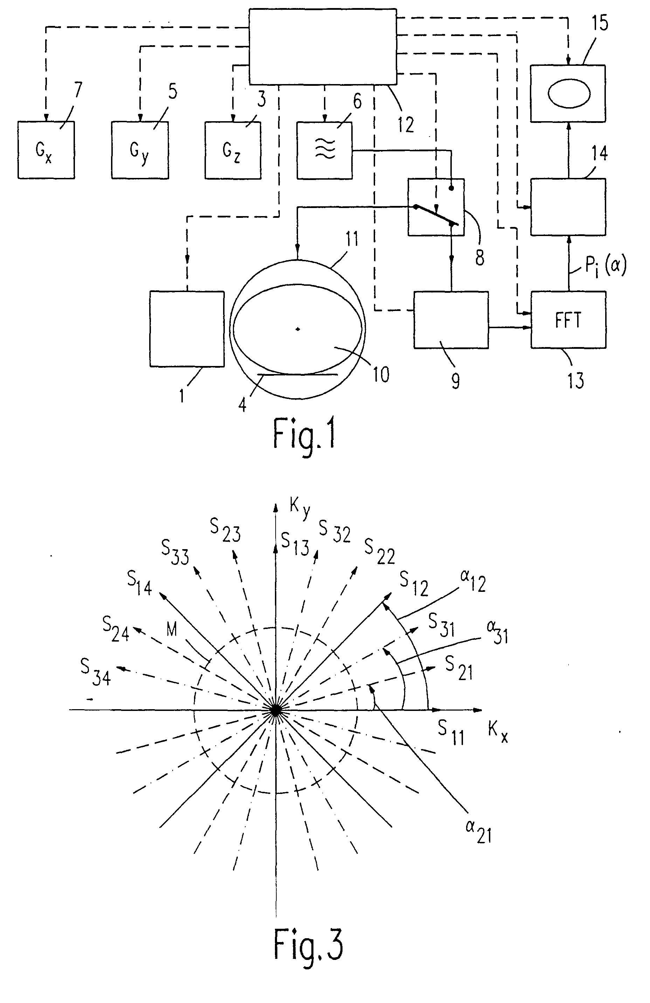

In Fig. 1 ist ein Blockschaltbild einer MR-Anordnung zur Durchführung des erfindungsgemäßen Verfahrens in schematischer Darstellung gezeigt. Mit 1 ist eine Anordnung zur Erzeugung eines homogenen stationären Magnetfeldes bezeichnet, die beispielsweise aus vier Spulen bestehen kann. Im Inneren dieser Anordnung befindet sich der zu untersuchende Patient 10 auf einer Tischplatte 4. Zur Erzeugung von sogenannten Gradienten-Magnetfeldern Gₓ, G_{y}, G_{z} sind drei Gradienten-Spulenanordnungen 3, 5, 7 vorgesehen. Diese erzeugen jeweils ein in Richtung des homogenen stationären Magnetfeldes verlaufendes und sich in einer der drei Raumrichtungen linear änderndes Magnetfeld.

Weiterhin ist eine Hochfrequenzspule 11 vorgesehen, die über einen Umschalter 8 wahlweise mit einem Oszillator 6 zum Erzeugen von Hochfrequenzimpulsen oder mit einem Empfänger 9 zum Empfangen der im Untersuchungsbereich erzeugten MR-Signale verbunden werden kann. Es ist jedoch auch möglich, zum Empfang der MR-Signale eine gesonderte, in Figur 1 nicht näher dargestellte Hochfrequenzempfangsspule zu verwenden. Die Steuerung der vorgenannten Elemente der MR-Anordnung erfolgt durch eine Steuereinheit 12, die insbesondere auch die zeitliche Abfolge der MR-Sequenzen steuert.

Durch eine FFT-Recheneinheit 13 werden aus den gemessenen MR-Signalen Projektionen Pᵢ (α) berechnet, aus denen nach dem erfindungsgemäßen Verfahren in der Rekonstruktionseinheit 14 ein artefaktfreies hochaufgelöstes MR-Bild rekonstruiert wird. Dieses kann anschließend auf der Ausgabeeinheit 15 dargestellt werden. Die Einheiten 13, 14, 15 werden ebenfalls von der Steuereinheit 12 gesteuert.

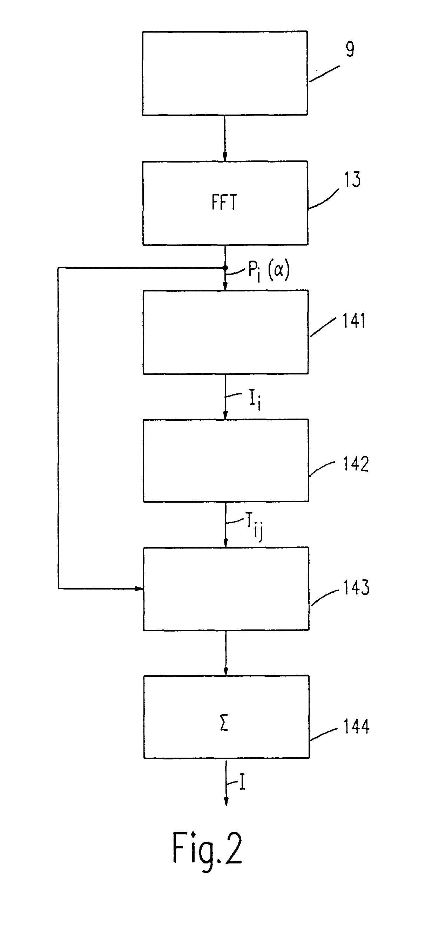

Anhand des in Figur 2 gezeigten Ablaufschemas soll das erfindungsgemäße Verfahren näher erläutert werden. Insbesondere sind darin die von der Rekonstruktionseinheit 14 durchgeführten Verfahrensschritte durch die Blöcke 141 bis 144 verdeutlicht.

Jedes im Empfänger 9 digitalisierte, am Empfängerausgang als Folge digitaler Abtastwerte vorliegende MR-Signal wird im Block 13 einer inversen Fouriertransformation unterzogen. Die daraus gewonnen Projektionen Pᵢ (α) werden anschließend dazu benutzt, mittels gefilterter Rückprojektion im Block 141 MR-Bilder Iᵢ zu rekonstruieren. Während herkömmlicherweise alle in einem bestimmten Zeitintervall ermittelten Projektionen Pᵢ (α), die bei der Abtastung des k-Raumes gewonnen wurden, dazu benutzt werden, ein hochaufgelöstes MR-Bild zu rekonstruieren, werden erfindungsgemäß zunächst mehrere niedrigaufgelöste MR-Bilder Iᵢ rekonstruiert, wobei für jedes niedrigaufgelöste MR-Bild Iᵢ nur eine Anzahl der zuvor gewonnenen Projektionen Pᵢ (α) zur Rekonstruktion verwendet wird. Jede Projektion Pᵢ (α) wird dabei genau ein einziges Mal verwendet. Beispielsweise werden statt eines hochaufgelösten MR-Bildes, das aus 180 Projektionen Pᵢ (α) rekonstruiert wird, erfindungsgemäß zunächst drei niedrigaufgelöste MR-Bilder Iᵢ (i=1...3) aus jeweils 60 Projektionen Pᵢ (α) rekonstruiert.

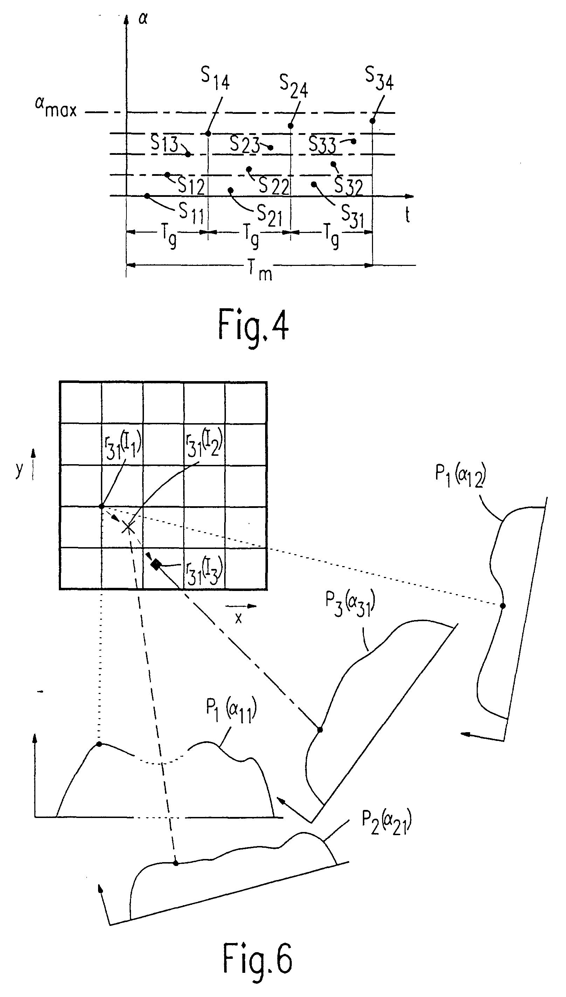

Zur Gewinnung der Projektionen Pᵢ (α) für ein niedrigaufgelöstes MR-Bild Iᵢ wird der k-Raum gleichmäßig abgetastet. Dies soll anhand von Figur 3, in der die Abtastung des k-Raumes gemäß der Erfindung gezeigt ist, erläutert werden. Jede MR-Sequenz bzw. jedes dabei erfaßte MR-Signal (aus dem mittels FFT eine Projektion berechnet wird) entspricht einer Geraden durch den Nullpunkt des k-Raumes, wobei die Richtung der Geraden der Gradientenrichtung der Gradientenmagnetfelder entspricht. In einem ersten Zeitraum wird der k-Raum auf den durchgezogen gezeichneten Pfaden S₁₁, S₁₂, S₁₃, S₁₄ abgetastet. Anschließend erfolgt die Abtastung auf den gestrichelt gezeichneten Pfaden S₂₁, S₂₂, S₂₃, S₂₄ und danach die Abtastung auf den strichpunktiert gezeichneten Pfaden S₃₁, S₃₂, S₃₃, S₃₄. Man erkennt, daß die Gradientenrichtungen einer Gruppe von Abtastungen sich von denen jeder anderen Gruppe jeweils um einen konstanten Winkel (α₂₁) unterscheiden, und zwar so, daß die Richtungen der N (im gezeigten Beispiel ist N=12) Abtastpfade der N/n (im Beispiel 12/4=3, n ist die Zahl der Abtastpfade pro Abtastgruppe) Abtastgruppen sich gleichmäßig über den k-Raum verteilen. Es gilt also im gezeigten Beispiel: α₃₁ = 2 α₂₁ und α₁₂ = 3 α₂₁.

Aus den Projektionen P₁, die entlang der Pfade S₁₁ bis S₁₄ der ersten Abtastgruppe gewonnen wurden und die zusammen einen ersten MR-Datensatz bilden, wird anschließend ein erstes niedrigaufgelöstes MR-Bild I₁ rekonstruiert, aus den Projektionen P₂ (dem zweiten MR-Datensatz) der zweiten Abtastgruppe (Pfade S₂₁ bis S₂₄) ein zweites niedrigaufgelöstes MR-Bild I₂ und aus den Projektionen P₃ (dem dritten MR-Datensatz) der dritten Abtastgruppe (Pfade S₃₁ bis S₃₄) ein drittes niedrigaufgelöstes MR-Bild I₃. Dies erfolgt mittels einer gefilterten Rückprojektion im Block 141, was bedeutet, daß nur die innerhalb des Kreises M im k-Raum liegenden Daten der Projektionen zur Rekonstruktion benutzt werden, da außerhalb dieses Kreises die Dichte der Abtastpunkte zu gering ist.

Die zeitliche Abfolge der Abtastungen ist nochmals in Figur 4 näher gezeigt, wobei als Ordinate die Gradientenrichtung α und als Abzisse die Zeit t aufgetragen ist.

Jeder Punkt in diesem Diagramm entspricht der Erfassung eines MR-Signales. Der Winkelbereich zwischen 0 und αₘₐₓ ist dabei der Bereich der Gradientenrichtungen, der für die Rekonstruktion eines hochaufgelösten MR-Bildes erforderlich ist. Zu erkennen ist, daß in jeweils einem Zeitraum T_{g} nacheinander die Pfade einer Abtastgruppe durchlaufen werden. Im ersten Zeitraum T_{g} werden beispielsweise die Pfade der ersten Abtastgruppe zur Erfassung des Projektionen P₁ durchlaufen werden. Insgesamt wird im gezeigten Beispiel die Zeit Tₘ = 3 T_{g} (allgemein: Tₘ = N/n T_{g} ) benötigt.

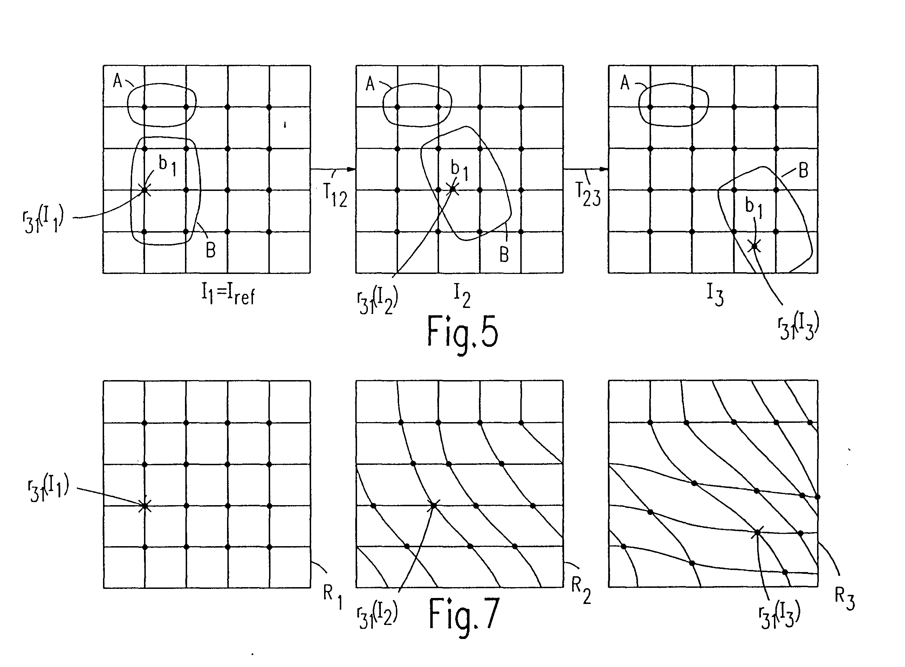

Im Block 142 (Figur 2) werden nun die erhaltenen niedrigaufgelösten MR-Bilder Iᵢ miteinander verglichen und daraus die Bild-Transformationsparameter Tᵢⱼ gewonnen. Dies soll anhand der Figur 5 näher erläutert werden.

Figur 5 zeigt drei zeitlich aufeinander folgende niedrigaufgelöste MR-Bilder I₁, I₂, I₃, die beispielsweise aus Projektionen einer Abtastung des k-Raumes gemäß Figur 3 gewonnen wurden. Es sind zwei Bildobjekte A und B zu erkennen, von denen sich das Bildobjekt B während der Erfassung der MR-Daten bewegt hat. Aus einem Vergleich des zweiten MR-Bildes I₂ mit dem als Referenzbild I_{ref} dienenden ersten MR-Bild I₁ werden die Bild-Transformationsparameter T₁₂ und aus dem Vergleich des dritten MR-Bildes I₃ mit dem zweiten MR-Bild I₂ die Bild-Transformationsparameter T₂₃ gewonnen. Dazu werden im Referenzbild I_{ref} Bildpunkte an ausgewählten Stellen, beispielsweise auf den Rasterpunkten des zur Rekonstruktion des Referenzbildes I_{ref} benutzten Rasters R₁ bestimmt und die Lage dieser Bildpunkte in den nachfolgenden MR-Bildern I₂, I₃ bestimmt. Beispielhaft soll dies anhand des Bildpunkte b₁ erläutert werden.

Der Bildpunkt b₁ des Bildobjektes B liegt im Referenzbild I_{ref} auf dem Rasterpunkt r₃₁(I₁) des Rasters R₁. Aufgrund der Bewegung des Bildobjektes B verändert sich in den Bildern I₂ und I₃ auch die Lage des Bildpunktes b₁, wie aus Figur 5 zu erkennen ist. Aus dem Vergleich der Lage des Bildpunktes b₁ in den drei niedrigaufgelösten MR-Bildern I₁, I₂, I₃ werden also die Bild-Transformationsparameter für den auf dem Rasterpunkt r₃₁ liegenden Bildpunkt b, bestimmt. Die Lage eines ausgewählten Bildpunktes kann in den MR-Bildern beispielsweise dadurch bestimmt werden, daß die dem Bildpunkt zugeordnete Intensität (sein Bildwert) im Referenzbild ermittelt und die Lage des Bildpunktes anhand seines Bildwertes in den anderen MR-Bildern bestimmt wird. Eine mathematische Methode dazu ist beispielsweise aus IEEE, Transactions on Circuits and Systems for Video Technology, Vol. 3, Nr. 5 (1993), S. 368 bekannt.

Dieses Vorgehen erfolgt für alle auf den Rasterpunkten des Rasters R₁ im Referenzbild I_{ref} liegenden Bildpunkte, woraus alle Bild-Transformationsparameter T₁₂ und T₂₃ gewonnen werden.

Aus den Bild-Transformationsparametern Tᵢⱼ und den Projektionen Pᵢ (α) werden anschließend im Block 143 (Figur 2) die Bildwerte des hochaufgelösten MR-Bildes I berechnet. Anhand der Figur 6 soll die Berechnung eines Bildwertes des hochaufgelösten MR-Bildes I näher erläutert werden. Gezeigt ist dort der Ortsraum des hochaufgelösten MR-Bildes I mit den Koordinaten x und y.

Zunächst wird an der Stelle r₃₁(I₁), an der der Bildpunkt b₁ im ersten niedrigaufgelösten MR-Bild I₁ liegt, ein erster Teil-Bildwert aus der ersten Projektion P₁ (α₁₁) rekonstruiert. In der Zeichnung ist dies durch die gepunktete Linie von der Projektion P₁ (α₁₁) zur Stelle r₃₁(I₁) angedeutet. An derselben Stelle. werden aus den weiteren Projektionen P₁ (α_{1ν}, ν=2, 3, 4), die entlang der weiteren Pfade S₁₂ bis S₁₄ der ersten Abtastgruppe (Figur 3) gewonnen wurden, weitere Teil-Bildwerte rekonstruiert und zum ersten Teil-Bildwert addiert. In der Zeichnung ist davon nur die Rekonstruktion aus der Projektion P₁ (α₁₂) durch eine gepunktete Linie angedeutet.

Anschließend werden an der Stelle r₃₁(I₂), an der der Bildpunkt b₁ im zweiten niedrigaufgelösten MR-Bild I₂ liegt, Teil-Bildwerte aus den Projektionen P₂ (α_{2ν}, ν=1, 2. 3, 4), die entlang der Pfade S₂₁ bis S₂₄ der zweiten Abtastgruppe gewonnen wurden, rekonstruiert und addiert. Gleiches erfolgt an der Stelle r₃₁(I₃), an der der Bildpunkt b₁ im dritten niedrigaufgelösten MR-Bild I₃ liegt, aus den Projektionen P₃ (α₃_{*ν*}, ν=1, 2, 3, 4) der dritten Abtastgruppe (Pfade S₃₁ bis S₃₄). In der Zeichnung ist dies durch eine gestrichelte Linie von der Projektion P₂ (α₂₁) zur Stelle r₃₁(I₂) bzw. durch eine strichpunktierte Linie von der Projektion P₃ (α₃₁) zur Stelle r₃₁(I₃) angedeutet.

Anschließend werden alle ermittelten Teil-Bildwerte im Block 144 (Figur 2) addiert, woraus sich der Bildwert des hochaufgelösten MR-Bildes ergibt, der an der Stelle r₃₁(I₁) liegt. Bei der beschriebenen Rekonstruktion der Teil-Bildwerte werden die gesamten Daten der entlang der Pfade im k-Raum ermittelten Projektionen verwendet und nicht nur - wie bei der Erstellung der niedrigaufgelösten MR-Bilder - die innerhalb des Kreises M liegenden Daten der Projektionen.

Dieses Verfahren wird für alle Rasterpunkte rₖₗ (k=1, 2, ..., K; l=1, .... L; K=Anzahl der Rasterpunkte in y-Richtung, L=Anzahl der Rasterpunkte in x-Richtung) des Rasters R₁ wiederholt, d.h. alle Bildwerte des hochaufgelösten MR-Bildes I ergeben sich aus Teil-Bildwerten, welche jeweils aus unterschiedlichen Projektionen durch Rekonstruktion auf unterschiedlichen Rasterpunkten gewonnen werden. Anders ausgedrückt bedeutet dies, daß die ersten Teil-Bildwerte auf dem Grundraster R₁ aus den Projektionen P₁ der ersten Abtastgruppe und die weiteren Teil-Bildwerte auf Rastern, welche sich aus dem Grundraster durch eine Transformation mittels der Bild-Transformationsparameter ergeben, aus den Projektionen der weiteren Abtastgruppen rekonstruiert, anschließend addiert und auf dem Grundraster R₁ dargestellt werden.

Die verschiedenen Raster R₁ bis R₃ sind in Figur 7 gezeigt. Das Grundraster R₁, auf dem das hochaufgelöste MR-Bild I rekonstruiert und dargestellt werden soll, entspricht dem Raster R₁ des ersten niedrigaufgelösten MR-Bildes I₁. Das Raster R₂ wird aus dem Grundraster R₁ mittels der Bild-Transformationsparameter T₁₂ gewonnen, indem aus den Koordinaten jedes Rasterpunktes des Rasters R₁ mittels des zugehörigen Transformationsparameters die Koordinaten der neuen Rasterpunkte des Raster R₂ berechnet werden. Auf die gleiche Weise wird das Raster R₃ aus dem Raster R₂ mittels der Bild-Transformationsparameter T₂₃ gewonnen. Beispielsweise wird der Rasterpunkt r₃₁(I₁) des Rasters R₁ auf den Rasterpunkt r₃₁(I₂) im Raster R₂ verschoben, an dem der Bildpunkt b₁ im MR-Bild I₂ lag, und auf den Rasterpunkt r₃₁(I₃) im Raster R₃ verschoben, an dem der Bildpunkt b₁ im MR-Bild I₃ lag. Auf den Rasterpunkten dieser Raster R₁, R₂, R₃ werden dann wie bereits erläutert die Teil-Bildwerte rekonstruiert, die zu dem Bildwert des hochaufgelösten MR-Bildes addiert werden.

Bei der Berechnung der Bild-Transformationsparameter müssen die Bildpunkte im Referenzbild, deren Lage in den weiteren niedrigaufgelösten MR-Bildern verfolgt wird, nicht auf einem Raster liegen. Es kann dazu auch eine beliebige Anzahl von Bildpunkten an beliebigen (aber bekannten) Stellen ausgewählt werden. Die Bild-Transformationsparameter können auch mit einer Genauigkeit bestimmt werden, die unterhalb der Größe eines Bildpunktes bzw. unterhalb der Größe des Abstandes zwischen-zwei Bildpunkten liegt.

Vor der Berechnung der Bild-Transformationsparameter könnten die niedrigaufgelösten MR-Bilder auch zunächst mit mathematischen Methoden gezoomt werden und auf dem Raster eines hochaufgelösten MR-Bildes dargestellt werden. Es könnten dann nach dem beschriebenen Verfahren die Bild-Transformationsparameter an den Rasterpunkten des hochaufgelösten MR-Bildes bestimmt werden, wodurch mehr Bild-Transformationsparameter erhalten und letztlich eine höhere Genauigkeit erreicht werden.

Anstelle des zeitlich ersten niedrigaufgelösten MR-Bildes könnte auch ein anderes MR-Bild als Referenzbild ausgewählt werden, von dem ausgehend die Bild-Transformationsparameter bestimmt und das hochaufgelöste MR-Bild später rekonstruiert wird. Das hochaufgelöste MR-Bild zeigt dann die Lage der Bildobjekte in einer späteren Bewegungsphase, nämlich zu dem Zeitpunkt, zu dem der zum Referenzbild gehörige MR-Datensatz erfaßt wurde.

Anstelle der Projektions-Rekonstruktions-Methode könnte auch die Diskrete Fouriertransformation zur Erstellung der niedrigaufgelösten MR-Bilder und/oder des hochaufgelösten MR-Bildes eingesetzt werden, was jedoch auf Grund der erforderlichen Berechnung der Bildwerte auf unregelmäßigen Rastern deutlich mehr Zeit in Anspruch nimmt.

Das erfindungsgemäße Verfahren findet Anwendung, wenn im Verlauf der Bildaufnahme keine neuen Bildobjekte in den Untersuchungsbereich kommen, sich aber die Lage der Bildobjekte relativ zueinander verändern kann. Diese Situation tritt z.B. auf, wenn dynamische Studien von Gelenken gemacht werden sollen. Teile der Anatomie werden bei der Bewegung verschoben und/oder verzerrt, die Anatomie selbst ändert sich aber nicht.

## Patentansprüche

1. MR-Verfahren zur Reduzierung von Bewegungsartefakten, bei dem zeitlich nacheinander mehrere MR-Datensätze eines Untersuchungsobjektes erfaßt werden,
**dadurch gekennzeichnet, daß** aus jedem der aus einer Anzahl von MR-Signalen abgeleiteten MR-Datensätze je ein räumlich niedrigaufgelöstes MR-Bild (Iᵢ) rekonstruiert wird, daß aus einem Vergleich der niedrigaufgelösten MR-Bilder (Iᵢ) Bild-Transformationsparameter (Tᵢⱼ) ermittelt werden und daß aus den MR-Datensätzen in Abhängigkeit der Bild-Transformationsparameter (Tᵢⱼ) ein hochaufgelöstes MR-Bild (I) mit einer im Vergleich zu den niedrigaufgelösten MR-Bildern (Iᵢ) vergrößerten räumlichen Auflösung rekonstruiert wird.

2. MR-Verfahren nach Anspruch 1,
**dadurch gekennzeichnet, daß** die Lage von Bildpunkten in einem als Referenzbild (I_{ref}) dienenden niedrigaufgelösten MR-Bild (I₁) bestimmt wird, daß die Lage der Bildpunkte in den übrigen niedrigaufgelösten MR-Bildern (Iᵢ) bestimmt wird und daß aus dem Vergleich der Lage der Bildpunkte im Referenzbild (I_{ref}) mit der Lage der Bildpunkte in den übrigen niedrigaufgelösten MR-Bildern (Iᵢ) die Bild-Transformationsparameter (Tᵢⱼ) ermittelt werden.

3. MR-Verfahren nach Anspruch 2,
**dadurch gekennzeichnet, daß** im Referenzbild (I_{ref}) die Lage von Bildpunkten an Stellen bestimmt wird, die Rasterpunkten (rₖₗ) eines Rasters (R₁) entsprechen, auf dem das hochaufgelöste MR-Bild (I) rekonstruiert wird.

4. MR-Verfahren nach Anspruch 1,
**dadurch gekennzeichnet, daß** die Bildwerte des hochaufgelösten MR-Bildes (I) jeweils durch eine Addition von Teil-Bildwerten ermittelt werden, von denen ein erster Teil-Bildwert aus einem ersten MR-Datensatz durch Rekonstruktion auf einem Rasterpunkt eines Grundrasters (R₁) ermittelt wird und die weiteren Teil-Bildwerte jeweils aus einem der übrigen MR-Datensätze durch Rekonstruktion auf einem Rasterpunkt eines Rasters (R₂, R₃) ermittelt werden, welches aus dem Grundraster (R₁) mittels der zugehörigen Bild-Transformationsparameter (Tᵢⱼ) ermittelt wird.

5. MR-Verfahren nach Anspruch 1,
**dadurch gekennzeichnet, daß** zur Rekonstruktion des hochaufgelösten MR-Bildes (I) aus einem MR-Datensatz ein MR-Grundbild auf einem Grundraster (R₁) erstellt wird, daß aus den übrigen MR-Datensätzen jeweils ein MR-Bild auf einem weiteren Raster (R₂, R₃) erstellt wird, welches aus dem Grundraster (R₁) mittels der zugehörigen Bild-Transformationsparameter (Tᵢⱼ) ermittelt wird, und daß das MR-Grundbild und die MR-Bilder zu einem hochaufgelösten MR-Bild (I) überlagert werden.

6. MR-Verfahren nach Anspruch 1,
**dadurch gekennzeichnet, daß** zur Erfassung eines MR-Datensatzes der k-Raum auf in radialer Richtung durch den Nullpunkt des k-Raumes verlaufenden Pfaden (Sᵢⱼ) abgetastet wird.

7. MR-Verfahren nach Anspruch 6,
**dadurch gekennzeichnet, daß** die zur Erfassung eines MR-Datensatzes durchlaufenen Pfade (Sᵢⱼ) sich mit den zur Erfassung der weiteren MR-Datensätze durchlaufenen Pfaden (Sᵢⱼ) schneiden.

8. MR-Verfahren zur Reduzierung von Bewegungsartefakten, bei dem zeitlich nacheinander mehrere MR-Datensätze eines Untersuchungsobjektes erfaßt werden,
**dadurch gekennzeichnet, daß** parallel zur Erfassung der MR-Datensätze die Lage von an vorbestimmten Positionen des Untersuchungsobjektes angeordneten Mikrospulen erfaßt wird, daß aus dem Vergleich zeitlich aufeinanderfolgender Lagedaten der Mikrospulen Bild-Transformationsparameter (Tᵢⱼ) ermittelt werden und daß aus den MR-Datensätzen in Abhängigkeit der Bild-Transformationsparameter (Tᵢⱼ) ein hochaufgelöstes MR-Bild (I) rekonstruiert wird.

9. MR-Verfahren nach Anspruch 1 oder Anspruch 8,
**dadurch gekennzeichnet, daß** ein oder mehrere niedrigaufgelöste MR-Bilder (Iᵢ) und/oder das hochaufgelöste MR-Bild (I) dargestellt werden.

10. MR-Anordnung zur Durchführung des Verfahrens nach Anspruch 1 mit Mitteln (14) zum Erzeugen von MR-Bildern aus MR-Signalen, einer programmierbaren Steuereinheit (12) zum Steuern der vorgenannten Mittel und einer Rekonstruktionseinheit (14) zum Rekonstruieren von MR-Bildern nach der Projektions-Rekonstruktions-Methode,
**dadurch gekennzeichnet, daß** die Steuereinheit (12) derart programmiert ist, daß zeitlich nacheinander mehrere MR-Datensätze eines Untersuchungsobjektes erfaßt werden, wobei aus jedem der aus einer Anzahl von MR-Signalen abgeleiteten MR-Datensätze je ein räumlich niedrigaufgelöstes MR-Bild (Iᵢ) rekonstruiert wird, daß aus einem Vergleich der niedrigaufgelösten MR-Bilder (Iᵢ) Bild-Transformationsparameter (Tᵢⱼ) ermittelt werden und daß aus den MR-Datensätzen in Abhängigkeit der Bild-Transformationsparameter (Tᵢⱼ) ein hochaufgelöstes MR-Bild (I) mit einer im Vergleich zu den niedrigaufgelösten MR-Bildern (Iᵢ) vergrößerten räumlichen Auflösung rekonstruiert wird.

## Claims

1. An MR method for the reduction of motion artefacts in which a plurality of MR data sets concerning an object to be examined are acquired successively in time,
**characterized in that** a respective low-resolution MR image (Iᵢ) is reconstructed from each one of the MR data sets which are derived from a plurality of MR signals, that image transformation parameters (Tᵢⱼ) are determined from a comparison of the low-resolution MR images (Iᵢ), and that a high-resolution MR image (I) with an increased spatial resolution compared to the low-resolution MR images (Iᵢ) is reconstructed from the MR data sets in dependence on the image transformation parameters (Tᵢⱼ).

2. An MR method as claimed in Claim 1,
**characterized in that** the location of pixels in a low-resolution MR image (I₁) which acts as a reference image (I_{ref}) is determined, that the location of the pixels in the other low-resolution MR images (Iᵢ) is determined, and that the image transformation parameters (Tᵢⱼ) are determined from the comparison of the location of the pixels in the reference image (I_{ref}) with the location of the pixels in the other low-resolution MR images (Iᵢ).

3. An MR method as claimed in Claim 2,
**characterized in that** in the reference image (I_{ref}) the position of pixels is determined at locations that correspond to raster points (Rₖₗ) of a raster (R₁) at which the high-resolution MR image (I) is reconstructed.

4. An MR method as claimed in Claim 1, **characterized in that** the image values of the high-resolution MR image (I) are determined by a respective addition of sub-image values, a first sub-image value being determined from a first MR data set by reconstruction at a raster point of a basic raster (R₁) while the further sub-image values are determined from a respective one of the other MR data sets by reconstruction at a raster point of a raster (R₂, R₃) derived from the basic raster (R₁) by means of the associated image transformation parameter (Tᵢⱼ).

5. An MR method as claimed in Claim 1,
**characterized in that** for the reconstruction of the high-resolution MR image (I), an MR basic image is formed from an MR data set on a basic raster (R₁), that a respective MR image is formed from the remaining MR data sets on a further raster (R₂, R₃) derived from the basic raster (R₁) by means of the associated image transformation parameter (Tᵢⱼ), and that the MR basic image and the MR images are superposed so as to form a high-resolution MR image (I).

6. An MR method as claimed Claim 1,
**characterized in that** in order to acquire an MR data set the k space is scanned along paths (Sᵢⱼ) extending radially through the zero point of the k space.

7. An MR method as claimed in Claim 6,
**characterized in that** the paths (Sᵢⱼ) followed to acquire an MR data set intersect the paths (Sᵢⱼ) followed to acquire the further MR data sets.

8. An MR method for the reduction of motion artefacts in which a plurality of MR data sets concerning an object to be examined are acquired successively in time,
**characterized in that** parallel to the acquisition of the MR data sets the location of microcoils arranged at predetermined positions of the object to be examined is determined, that image transformation parameters (Tᵢⱼ) are determined from the comparison of temporally successive location data of the microcoils, and that a high-resolution MR image (I) is reconstructed from the MR data sets in dependence on the image transformation parameters (Tᵢⱼ).

9. An MR method as claimed in Claim 1 or Claim 8,
**characterized in that** one or more low-resolution MR images (Iᵢ) and/or the high-resolution MR image (I) are displayed.

10. An MR device for carrying out the method as claimed in Claim 1, including means (14) for generating MR images from MR signals, a programmable control unit (12) for controlling said means, and a reconstruction unit (14) for reconstructing MR images by means of the projection-reconstruction method, **characterized in that** the control unit (12) is programmed such that a plurality of MR data sets of an object to be examined are acquired successively in time, and that from each one of the data sets derived from a plurality of MR signals a respective low-resolution MR image (Iᵢ) is reconstructed, that image transformation parameters (Tᵢⱼ) are determined from the comparison of the low-resolution MR images (Iᵢ), and that a high-resolution MR image (I) with an increased spatial resolution compared to the low-resolution MR images (Iᵢ) is reconstructed from the MR data sets in dependence on the image transformation parameters (Tᵢⱼ).

## Revendications

1. Procédé RM de réduction d'artefacts de mouvement, dans lequel plusieurs jeux de données RM d'un objet d'examen sont enregistrés successivement dans le temps, qu'une image RM (Iᵢ) de faible résolution spatialement est respectivement reconstruite à partir de chacun des jeux de données RM dérivés d'un nombre de signaux RM, que des paramètres de transformation de l'image (Tᵢⱼ) sont déterminés à partir d'une comparaison des images RM (Ii) de basse résolution et qu'une image RM (I) de haute résolution est reconstruite à partir des jeux de données RM en fonction des paramètres de transformation de l'image (Tᵢⱼ) avec une résolution spatiale agrandie par rapport aux images RM (Iᵢ) de faible résolution.

2. Procédé RM selon la revendication 1, **caractérisé en ce que** la position des pixels est déterminée dans une image RM (I₁) à basse résolution servant d'image de référence (I_{ref}), que la position des pixels est déterminée dans les autres images RM (Iᵢ) à basse résolution et que les paramètres de transformation de l'image (Tᵢⱼ) sont déterminés à partir de la comparaison de la position des pixels dans l'image de référence (I_{ref}) avec la position des pixels dans les autres images RM (Iᵢ) à basse résolution.

3. Procédé RM selon la revendication 2, **caractérisé en ce que** la position des pixels est déterminée dans l'image de référence (I_{ref}) aux endroits qui correspondent aux points de trame (rₖᵢ) d'une trame (R₁) sur laquelle l'image RM (I) à haute résolution est reconstruite.

4. Procédé RM selon la revendication 1, **caractérisé en ce que** les valeurs d'image de l'image RM (I) à haute résolution sont respectivement déterminées par une addition de valeurs d'image partielles par lesquelles une première valeur d'image partielle est déterminée à partir d'un premier jeu de données RM par reconstruction sur un point de trame d'une trame de base (R₁) et les autres valeurs d'image partielles sont respectivement déterminées à partir d'un des autres jeux de données RM par reconstruction sur un point de trame d'une trame (R₂, R₃) qui est déterminée à partir de la trame de base (R₁) à l'aide des paramètres correspondants de transformation de l'image (Tᵢⱼ).

5. Procédé RM selon la revendication 1, **caractérisé en ce qu'**une image RM de base est établie sur une trame de base (R₁) à partir d'un jeu de données RM pour la reconstruction de l'image RM (I) à haute résolution, qu'à partir des autres jeux de données RM, une image RM est respectivement établie sur une autre trame (R₂, R₃) qui est déterminée à partir de la trame de base (R₁) à l'aide des paramètres correspondants de transformation de l'image (Tᵢⱼ) et que l'image de base RM et les images RM sont superposées en une image RM (I) à haute résolution.

6. Procédé RM selon la revendication 1, **caractérisé en ce que** l'espace k est balayé sur des voies (Sᵢⱼ) s'étendant en direction radiale par le point zéro de l'espace k en vue de la saisie d'un jeu de données RM.

7. Procédé selon la revendication 6, **caractérisé en ce que** les voies (Sᵢⱼ) traversées en vue de la saisie d'un jeu de données RM croisent les voies (Sᵢⱼ) traversées pour la saisie des autres jeux de données RM.

8. Procédé RM de réduction des artefacts de mouvement dans lequel plusieurs jeux de données RM d'un objet d'examen sont enregistrés successivement dans le temps, **caractérisé en ce que**, parallèlement à l'enregistrement des jeux de données RM, la position de microbobines disposées à des endroits préalablement déterminés de l'objet d'examen, que des paramètres de transformation d'image (Tᵢⱼ) sont déterminés à partir de la comparaison des données de position successives dans le temps des microbobines et qu'à partir des jeux de données RM, une image RM (I) à haute résolution est reconstruite en fonction des paramètres de transformation de l'image (Tᵢⱼ).

9. Procédé selon l'une des revendications 1 ou 8, **caractérisé en ce qu'**une ou plusieurs images RM (Iᵢ) à basse résolution et/ou l'image RM (I) à haute résolution sont représentées.

10. Dispositif RM d'exécution du procédé selon la revendication 1 avec des moyens (14) pour la production d'images RM à partir de signaux RM, d'une unité de commande programmable (12) pour la commande desdits moyens et d'une unité de reconstruction (14) pour la reconstruction d'images RM selon la méthode de reconstruction par projection, **caractérisé en ce que** l'unité de commande (12) est programmée de telle sorte que plusieurs jeux de données d'un objet d'examen sont saisis successivement dans le temps, dans lequel une image RM (Iᵢ) de faible résolution spatialement est respectivement reconstruite à partir de chacun des jeux de données RM dérivés d'un nombre de signaux RM, des paramètres de transformation de l'image (Tᵢⱼ) sont déterminés à partir d'une comparaison des images RM (Iᵢ) de basse résolution et une image RM (I) de haute résolution est reconstruite à partir des jeux de données RM en fonction des paramètres de transformation de l'image (Tᵢⱼ) avec une résolution spatiale agrandie par rapport aux images RM (Iᵢ) de faible résolution.
